# EUROPEAN PATENT APPLICATION

(11) **EP 1 217 807 A1**
(43) Date of publication of application: **26.06.2002**
(21) Application number: 00610132.3
(22) Date of filing: 19.12.2000
(51) Int. Cl.: H04M 1/02, H05K 1/14

(54) **A printed circuit board ( PCB) unit**

(71) Applicant: Telefonaktiebolaget L M Ericsson (Publ), 126 25 Stockholm (SE)
(72) Inventor: Mendolia, Samuel, 223 59 Lund (SE)
(74) Representative: Sigh, Erik

(57) **Abstract**

A printed circuit board unit (PCB unit) provided with relatively light/small (2) and relatively heavy/large electrical components (6,7,8). The PCB unit comprises a printed circuit board (PCB) (1) provided with a printed circuit and with at least some of the light/small electrical components (2) mounted on the PCB (1) and a module (3) that is mechanically connected to the PCB (1). The module (3) is electrically connected to the PCB (1) via complementary sets of terminals (4,5) provided on the module (3) and the PCB (1), respectively. The module (3) is provided with holding means for firmly holding at least some of the relatively heavy/large electrical components (6,7,8) and connecting means for electrically connecting the relatively heavy/large electrical components (6,7,8) with the complementary set of terminals (5) of the module (3).

## Description

### Technical field

The invention relates to a printed circuit board unit (PCB unit) provided with relatively light/small and relatively heavy/large electrical components, said PCB unit comprising a printed circuit board (PCB) provided with a printed circuit and with at least some of the light/small electrical components mounted on the PCB, and a module that is mechanically connected to the PCB, said module being electrically connected to the PCB via complementary terminals provided on the module and the PCB, respectively.

### Related prior art

GB-A-2,216,728 discloses a PCB unit of this type in which more PCBs with electrical components can be interconnected in a modular manner. The PCB unit according to GB-A-2,216,728 is directed for use in industrial sewing machines, and the purpose of making the PCB unit modular is to be able to combine different PCBs for different applications. Each of the PCBs comprises a number of electrical components, some of which are light/small and some of which are heavy/large. However, all the electrical components are mounted on the PCB in a conventional way and there is therefore a risk that at least the heavy/large electrical components come loose if the device in which the PCB unit is mounted is dropped or otherwise exposed to an impact. Additionally, such mounting of heavy/large components also involves assembly and process related problems during manufacturing of the PCB unit.

### Object of the invention

In many electronic devices the requirement for saving space and weight is essential and therefore most of the electrical components applied in such electronic devices are very small. This is especially true for mobile electronic devices, such as mobile telephones, pagers, communicators, etc. However, not all electrical components can be made small and light. For instance, electrical components such as buzzers, speakers, LCDs, keys, vibrators, back-up capacitors, etc. are relatively heavy and/or large and these components have to be mounted in the electronic device in a safe manner connected to the main PCB of the electronic device.

There are three conventional ways to connect these heavy/large components to the main PCB. The first way is to connect the heavy/large electrical component or a holder therefor directly to the PCB by soldering. Soldering provides a good electrical connection between the component or the holder therefor, but provides weak mechanical strength between the component or the holder therefor. Due to the weak mechanical strength, large or high profile components, such as a buzzer or a back-up capacitor, often come loose if the electronic device is dropped, e.g. in a drop test. Furthermore, some heavy/large electrical components have to be soldered manually to the PCB which adds further to the manufacturing costs of the electronic device.

The second way of connecting heavy/large electrical components to the PCB is by means of spring connections, such as pogo pins or by small spring elements that are soldered to the PCB at one end and brought into contact with the heavy/large component with the other end. When this technique is applied, the heavy/large component is often mounted on another part of the electronic device, such as the housing, and is brought into contact with the spring connection during assembly of the device. Unfortunately, spring connections are often bent during assembly or repair which may cause failure of the electronic device. Even if there is a satisfactory electrical contact during the manufacturing test, the contact may be marginal and may be lost afterwards.

The third way of connecting heavy/large electrical components to the PCB is by means of conductive elastomers. However, such elastomers are often compressed or twisted during assembly of the electronic device such that adjacent pads of the elastomer are shorted together. Also, the elasticity of the elastomer may change over time which may cause failures in the electronic device. Therefore, use of a conductive elastomer may result in no connection, a poor connection that can fail over time, or a resistive connection that can degrade performance of the electronic device.

It is an object of the invention to provide a PCB unit as mentioned in the opening paragraph in which there is a reliable electrical contact between the heavy/large electrical component and the PCB and in which the risk of failure due to loss of contact is minimized.

### Summary of the invention

The object of the invention is achieved by providing the module with means for firmly holding at least some of the relatively heavy/large electrical components and for electrically connecting these relatively heavy/large electrical components with the complementary set of terminals of the module.

Since the heavy/large electrical components are mounted separately in the module, the connections between the heavy/large electrical components and the set of terminals of the module can be made very reliable using any applicable technique. It is therefore possible to obtain a steady and secure connection of the heavy/large electrical components and the module, whereby the risk of failure caused by a bad electrical connection is minimized.

The module is preferably a one-piece element provided with recesses for holding at least some of the heavy/large electrical components. It is thereby possible to manufacture the module in a moulding process, e.g. by injection moulding of a plastics material.

In a preferred embodiment the module comprises a connector portion that is interconnectable with the PCB and is provided with the complementary set of terminals of the module, and a component holder portion in which the heavy/large electrical components are mounted. The two portions are preferably arranged at right angles in relation to each other, so that the connector portion extends perpendicular to the PCB when mounted, while the component holder portion primarily extends in parallel with the plane of the PCB.

The module may be designed so that it can be slid over an edge of the PCB whereby the complementary sets of terminals become electrically connected. In this embodiment the mechanical connection between the PCB and the module is maintained due to friction.

In a preferred embodiment the edge of the PCB is provided with at least one notch receiving a part of the module, so that a distal end of the module is flush with the edge of the PCB. This means that the module does not extend beyond the outer periphery of the PCB, whereby the PCB unit can be made very compact.

In an alternative embodiment the module is snapped onto a frame that is mounted on the PCB whereby the module becomes a single sided mounted module that does not extend to the opposite side of the PCB. An advantage of this embodiment is that the frame can be positioned anywhere on the PCB, i.e. the module is not restricted to a position near the edge of the PCB.

Preferably the frame is made of metal and the side of the module that faces the frame is metallised, e.g. by adding a metal plate. Thereby the frame and the metallised side of the module form an effective RF (radio frequency) shielding for the electrical components on the PCB underneath the module.

The module may be designed to provide a space between the PCB and at least a part of the module and electrical components mounted on the PCB are provided in that space. By utilizing this space between the module and the PCB, a very compact PCB unit can be obtained.

The module may be a part of a front element for an electronic device, such as a mobile telephone, in which the PCB unit is applied. Thereby the PCB module not only serves as a holder for the heavy/large electrical components, but also serves as a structural and/or decorative part of the electronic device as such.

It shall be emphasised that the term "comprise/comprising" when used in this specification is taken to specify the presence of stated features, integers, steps or components but does not preclude the presence or addition of one or more other features, integers, steps components or groups thereof.

### Description of the drawings

The invention will be described in detail in the following with reference to the drawings in which
Fig. 1 shows a perspective view of a first embodiment of a PCB unit according to the invention in a disassembled state;
Fig. 2 shows an enlarged detail of the module shown in Fig. 1;
Fig. 3 shows a side view of the PCB unit shown in Fig. 1 in an assembled state;
Fig. 4 shows a side view of a second embodiment of a PCB unit according to the invention;
Fig. 5 shows a perspective view of one end of the PCB of the second embodiment shown in Fig. 4;
Fig. 6 shows a side view of a third embodiment of a PCB unit according to the invention; and
Fig. 7 shows a side view of a fourth embodiment of a PCB unit according to the invention.

### Detailed description of an embodiment of the invention

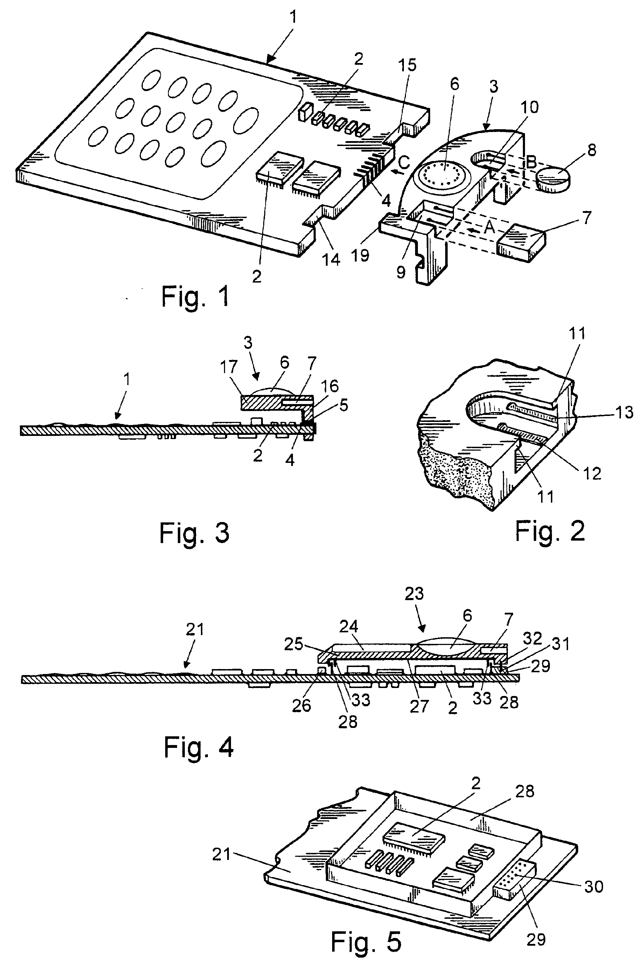

Fig. 1 shows a perspective view of a first embodiment of a PCB unit according to the invention in a disassembled state. The PCB unit comprises a double sided component mounted PCB 1 provided with electrical components 2 mounted thereon in a conventional way and a module 3 provided with means for holding at least some of the heavy/large electrical components provided in the PCB unit. The PCB unit is suitable for use in a large number of various electronic devices. However, a PCB unit according to the invention is particularly suitable for use in mobile electronic devices, such as mobile telephones, pagers, communicators, etc., since these devices often are exposed to impacts that could cause rupture of conventional connections between heavy/large electrical components and the PCB.

The PCB 1 can be in the shape of an ordinary PCB, i.e. a PCB provided with a printed circuit and various electrical components 2 connected to the printed circuit by any conventional method, e.g. by soldering. At one end of the PCB 1 a first set of terminals 4 is provided on the upper and/or lower side of the PCB 1. This first set of terminals 4 is connected to the printed circuit on the PCB 1 and is intended for contacting a complementary second set of terminals 5 (see Fig. 3) provided on the module 3. The two complementary sets of terminals 4,5 may be of any conventional type and a person skilled in the art will easily recognise such two sets of terminals 4,5.

In this first embodiment of a PCB unit according to the invention the module 3 is provided with three heavy/large electrical components: a speaker 6, a buzzer 7 and a back-up capacitor 8. The speaker 6 is already mounted in the module 3, whereas the buzzer 7 and the back-up capacitor 8 are to be slid into appropriate recesses 9,10 provided in the module as indicated with the arrows A and B.

As shown in Fig. 2, the upper surface of the module 3 forms lips 11 that partly cover the recesses 9,10 in order to withhold the electrical components 7,8 in the recesses. Furthermore, the recesses are provided with terminal strips 12,13 for electrically contacting the electrical components 7,8. The electrical components 7,8 may, however, be contacted in other ways than by terminal strips as shown.

The module is preferably made of an injection-moulded plastics material. This ensures that the module can be given almost any shape, with the recesses 9, 10 for holding the heavy/large components being integral parts of the module. The wiring for electrically connecting the electrical components 6-8 with the second set of terminals 5 can be an integral part of the module, i.e. the plastics material is injection moulded around the wiring, or the wiring can be added later, i.e. the wiring is positioned at the outer surface of the module 3.

When the buzzer 7 and the back-up capacitor 8 have been mounted in the appropriate recesses 9,10, the module 3 is slid onto the edge of the PCB 1 as indicated by the arrow C. The first set of terminals 4 provided on the PCB 1 thereby contacts the second complementary set of terminals 5 provided on the module 3 thus establishing electrical contact between the heavy/large electrical components 6-8 provided in the module 3 and the printed circuit of the PCB 1.

In the shown embodiment the edge of the PCB 1 is provided with notches 14,15 that allow the distal edge of the module 3 to be flush with the edge of the PCB 1 when mounted. This is shown in Fig. 3 that shows a cross-sectional side view of the PCB unit shown in Fig. 1 in an assembled state.

Fig. 3 shows how the module 3 comprises a connector part 16 perpendicular to the plane of the PCB 1 and a component holder part 17 that is practically parallel with the plane of the PCB 1. The connector part 16 is provided with means that frictionally engages with the PCB 1 when the module 3 is slid onto the edge of the PCB 1, and it is also provided with the second set of terminals 5 that contacts the first set of terminals 4 provided on the PCB 1. The engagement between the PCB 1 and the connector part 16 will not be described in details since it may be of any conventional type for connecting a module to a PCB.

The component holder part 17 of the module 3 extends parallel with and above the PCB 1. This arrangement of the component holder part 17 leaves a free space underneath the component holder part 17 which allows electrical components 2 to be mounted on the PCB underneath the component holder part 17. Thereby precious space in e.g. mobile devices can be utilised for mounting of components.

The component holder part 17 is in the embodiment shown in Figs 1-3 provided with a socket connector 19 (see Fig. 1) that is adapted for receiving a flexible ribbon cable connected to an LCD (liquid crystal display). The LCD with ribbon cable will be connected to the module 3 during assembly of the mobile telephone.

Fig. 4 shows a cross-sectional side view of a second embodiment of a PCB unit according to the invention. This embodiment corresponds essentially to the embodiment shown in Figs 1-3 except that the module 23 is substantially enlarged and that it is held in place by means of a metal frame 28 that is soldered to the PCB 21 rather than the module being slid over the edge of the PCB.

The module 23 is in this embodiment provided with a speaker 6, a buzzer 7 and optionally a back-up capacitor (not shown), like the embodiment shown in Figs 1-3. Furthermore, the module 23 is provided with an LCD 24 and a light guide 25 positioned underneath the LCD 24. The light guide 25 may be an integral part of the module 23 as shown, e.g. if the whole module is injection-moulded of a transparent plastics material suitable for use as a light transmitter, or it can be added to the module 23 as a separate component. An LED 26 (light emitting diode) or an LED component comprising more that one LED is provided on the PCB 21 adjacent one edge of the light guide 25.

The metal frame 28 provided on the PCB 21 is seen more clearly in Fig. 5 that shows one end of the PCB 21 in a perspective view. The metal frame 28 is soldered to the PCB 21 during the component mounting process which preferably is a surface mount assembly (SMA) process. A socket 29 provided with a number of socket openings 30 comprising a first set of terminals 31 (see Fig. 4) is a part of the metal frame 28 and is also soldered to the PCB 21. The second complementary set of terminals 32 is provided on the module 23 and consists of pins extending from the module 23. These pins are plugged into the socket 29 when the module 23 is mounted on the metal frame 28, thereby electrically connecting the PCB 21 and the module 23.

The socket/pin connection may provide some mechanical strength to the connection between the PCB 21 and the module 23. However, the module 23 is preferably provided with downwardly extending walls 33 that can be snapped onto the metal frame 28 and thereby achieve a firm connection between the PCB 21 and the module 23. The downwardly extending walls 33 are in the shown embodiment metallic and the rear side of the module 23 is provided with a metal plate 27, or optionally the rear side of the module 23 is electroplated or treated with a metal-coating in some manner. In the assembled state the metal frame 28 and the plate 27, forms an effective RF (radio frequency) shielding for the electrical components 2 on the PCB 21 underneath the module 23. The metal plate 27 and the metal frame 28 could also provide a direct ground path for the heavy/large electrical components 6,7,24 provided in the module 23 which would reduce the number of wires tracing back to the sets of terminals 31,32 forming the connector interface between the PCB 21 and the module 23.

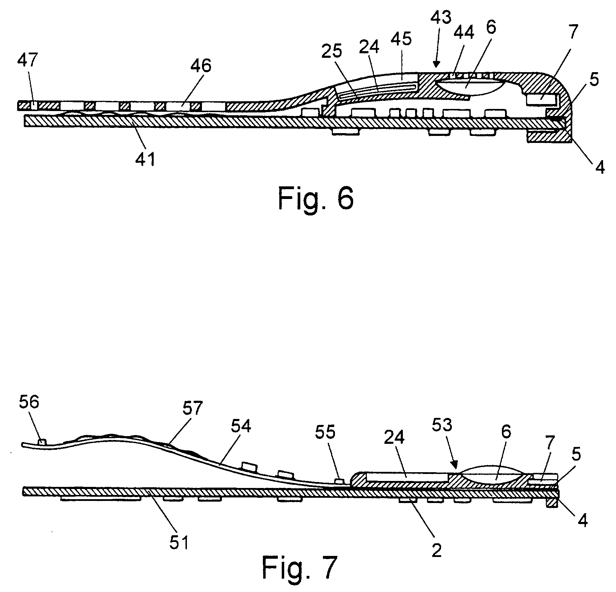

Yet another embodiment of a PCB unit according to the invention is shown in Fig. 6. In this embodiment the module 43 constitutes a front cover for the electronic device, such as a mobile telephone, in which the PCB unit is applied. Again the module 43 is provided with a speaker 6, a buzzer 7, a back-up capacitor (not shown), an LCD 24 and a light guide 25 for the LCD 24. The module further includes openings 44 for the speaker 6, an opening 45 through which the LCD can be seen and openings 46,47 for keys and a microphone that are not shown. The module 43 can be made in one piece as shown or can comprise more elements that are interconnected, by e.g. ultrasonical welding, gluing, snapping, etc. Also in this embodiment the connection between the PCB 41 and the module 43 is obtained by complementary sets of terminals 4,5 that are brought into electrical contact with each other by sliding the module 43 over one edge of the PCB 41.

In this embodiment the module 43 is substantially extended compared to the modules 23,33 shown in Figs 1-5 since it is not just an element positioned inside the electronic device, but constitutes a front cover thereof.

Yet another embodiment of a PCB unit according to the invention is shown in Fig. 7. In this embodiment the module 53 is not raised above the PCB 51 and it is particular relevant in connection with low thickness products. The module 53 is provided with a speaker 6, a buzzer 7 and a an LCD 24 and it is slid over the edge of the PCB 51 in the same manner as the modules 3 and 43 shown in Figs 1-3 and 6. Complementary terminal sets 4,5 are provided for electrically connecting the module 53 with the PCB 51.

Since the module 53 lies flat on the PCB 51 the thickness of the PCB unit is reduced and can be minimized almost to the height of the heavy/large components 6,7,24.

In the shown embodiment a single sided component mounted PCB 51 is applied, i.e. components 2 are mounted at one side of the PCB 51 only. This is very cost effective in high volume products since it requires the PCB 51 to go through the surface mount assembly (SMA) process once only and no reconfiguration of the PCB 51 for mounting components on the other side is needed. In order to compensate for the single sided mounting of the PCB 51, a flexible PCB 54 ("flex-film") is provided at the opposite side of the PCB 51. Components such as LEDs 55,56 and collapsible push-buttons domes 57 are mounted on the flexible PCB 54 and the flexible PCB 54 is positioned flat upon the PCB 51. The LED 55 (or an LED component comprising more than one LED) serves as a back-light for the LCD 24 possibly using the module 53 as a light guide.

The invention has been described with reference to the drawings which show preferred embodiments of the invention. The PCB unit may, however, be varied in a number of ways without departing from the general idea of the invention.

For instance, the module may be connected to the PCB in another way than shown in the drawings where it is slid over an edge of the PCB or snapped onto a metal frame provided on the PCB. The module may be soldered to the PCB or it may be mechanically connected to the PCB in other ways than by friction, e.g. by a use of screws or a clamping device.

The number and types of heavy/large electrical components mounted in the module may also be varied as desired and may therefore include other components than the ones shown in the drawings and described above.

Further, the PCB unit may comprise more than one module connected to the PCB if so desired.

## Claims

1. A printed circuit board unit (PCB unit) provided with relatively light/small (2) and relatively heavy/large electrical components (6,7,8,24), said PCB unit comprising a printed circuit board (PCB) (1;21;41;51) provided with a printed circuit and with at least some of the light/small electrical components (2) mounted on the PCB (1;21;41;51), and a module (3;23;43;53) that is mechanically connected to the PCB (1;21;41;51), said module (3;23;43;53) being electrically connected to the PCB (1;21;41;51) via complementary sets of terminals (4,5;31,32) provided on the module (3;23;43;53) and the PCB (1;21;41;51), respectively, **characterised in that** said module (3;23;43;53) is provided with holding means for firmly holding at least some of the relatively heavy/large electrical components (6,7,8,24) and connecting means for electrically connecting the relatively heavy/large electrical components (6,7,8,24) with the complementary set of terminals (5;32) of the module (3;23;43;53).

2. A PCB unit according to claim 1, **characterised in that** the module (3;23;43;53) is a one-piece element provided with recesses (9,10) for holding at least some of the heavy/large electrical components (7,8).

3. A PCB unit according to claims 1 or 2, **characterised in that** the module (3) comprises a connector portion (16) that is interconnectable with the PCB (1) and is provided with the complementary set of terminals (5) of the module (3), and a component holder portion (17) in which the heavy/large electrical components (6,7,8) are mounted.

4. A PCB unit according to any one of claims 1-3, **characterised in that** the module (3;43;53) is designed to be slid over an edge of the PCB (1;41;51) whereby the complementary sets of terminals (4,5) become electrically connected.

5. A PCB unit according to claim 4, **characterised in that** the edge of the PCB (1) is provided with at least one notch (14,15) receiving a part of the module (3), so that a distal end of the module (3) is flush with the edge of the PCB (1).

6. A PCB unit according to any one of claims 1-3, **characterised in that** the module (23) is snapped onto a frame (28) that is mounted on the PCB (21).

7. A PCB unit according to claim 6, **characterised in that** the frame (28) is made of metal and that the side of the module (23) facing the frame (28) is metallised.

8. A PCB unit according to claim 7, **characterised in that** the side of the module (23) facing the metal frame (28) is provided with a metal plate (27).

9. A PCB unit according to any one of claims 1-8, **characterised in that** there is provided a space between the PCB (1;21;41) and at least a part of the module (3;23;43), and that at least some electrical components (2) are mounted on the PCB (1;21;41) **in that** space.

10. An electronic device provided with a PCB unit according to any one of claims 1-9.

11. An electronic device according to claim 10, **characterised in that** the module (43) is a part of a front element for the electronic device.

12. An electronic device according to claim 10 or 11, **characterised in that** the device is a mobile radio station, such as a mobile telephone.
